# EUROPEAN PATENT SPECIFICATION

(11) **EP 0 603 271 B1**
(45) Date of publication and mention of the grant of the patent: **10.12.1997**
(21) Application number: 92919342.3
(22) Date of filing: 09.09.1992
(51) Int. Cl.: F24J 2/50, F24J 2/04

(54) **CLADDING PANELS FOR THE OPTIMISED TRANSMISSION OF ELECTROMAGNETIC, INCLUDING SOLAR RADIATION**
VERKLEIDUNGSPLATTEN FÜR OPTIMIERTE ÜBERTRAGUNG VON ELEKTROMAGNETISCHER STRAHLUNG EINSCHLIESSLICH SOLARSTRAHLUNG
PANNEAUX DE BARDAGE PRODUISANT UNE TRANSMISSION OPTIMALISEE DE RAYONNEMENTS ELECTROMAGNETIQUES, Y COMPRIS DU RAYONNEMENT SOLAIRE

(30) Priority: 14.09.1991 GB 9119674
(43) Date of publication of application: 29.06.1994
(73) Proprietor: MONYMUSK LAND COMPANY, Monymusk, Aberdeenshire AB51 7HS (GB); THE UNIVERSITY COURT OF THE UNIVERSITY OF ABERDEEN, Kings College, Aberdeen AB9 2UE (GB)
(72) Inventor: GRANT, Archibald, Aberdeenshire AB51 7HS (GB); IMBABI, Mohammed, Saleh-Eldin, Kings College Aberdeen AB9 2UE (GB)
(74) Representative: Orr, William McLean
(86) International application number: GB9201647
(87) International publication number: WO9306421

(56) References cited:
- EP-A- 0 071 230
- EP-A- 0 281 436
- DE-A- 2 832 545
- DE-A- 3 436 618
- FR-A- 2 478 800
- US-A- 3 718 078
- US-A- 4 033 324
- US-A- 4 078 548
- US-A- 4 458 672

## Description

This invention relates to a solar collection building panel which is intended to be arranged to receive solar radiation on one or more outer surface of the panel, and to transmit the radiation into or through the panel to impinge upon any suitable transducer or thermal exchange medium which converts the energy of the transmitted solar radiation into any required form, e.g. to heat up a supply of fluid fed to the under-side of the panel, or to energise photovoltaic cells encapsulated by the panel, or any combination thereof, including tandem, multi-layer, or multiple use (e.g. photovoltaic/thermal, thermal/ window etc.) arrangements.

Glazing and shading provide alternative means of regulating the amount of solar gain in buildings. Where successfully applied, their use has led to reductions in the consumption of conventional energy for heating, ventilating, cooling and lighting. However, greater use of solar energy in buildings has suffered from limited knowledge and a shortage of appropriate solar building materials and devices. Therefore, while solar panels have been developed for domestic and other uses, generally speaking the costs of construction and installation have remained high, particularly in temperate regions of the world where the available solar energy in winter months is greatly reduced.

Currently available solar cladding materials all share the following deficiencies:-
1) Directionality - where a significant proportion of the oblique incident radiation is simply reflected by the outer cladding and therefore a sizeable part of the available energy is lost. This phenomenon has led in the past to problems of siting and orientation of solar collectors, where the objective was to increase the fraction of solar radiation transmitted by the cladding. Because of the limitations associated with this type of solution (the most obvious being that the direction of "maximum" incident solar radiation varies with time), such remedies have so far been only partially successful.
2) Low aesthetic appeal - where very often the appearance of a solar collector or cladding material mitigates against their use. In general, the currently available solar cladding materials differ visibly from their non-solar counterparts. They are therefore difficult to incorporate in the majority of buildings where traditional appearance is considered an important factor, i.e. they are unacceptable from the architectural and aesthetic perspective.
3) Characteristic appearance - where each type of solar collector or cladding material looks different. This results in visual chaos when attempting to match, for example, the appearance of solar, thermal, photovoltaic and lighting systems.
4) Low strength and durability - when compared to that of most other building components.
5) High initial cost - which has limited the appeal of solar energy as an alternative to conventional energy sources in the past. This is especially true in the case of buildings, where buyers have demonstrated their reluctance to invest more in solar powered energy-saving features. Solar building designs must therefore cost no more than traditional designs if they are to gain widespread appeal.

In Scotland, as in many temperate parts of the world, the following restrictions also apply:-
6) The amount of direct solar radiation throughout the year is generally less than that in other latitudes. The need to utilise diffuse solar and sky (or omni-directional) radiation components efficiently is therefore proportionately greater.
7) Architectural standards in Scotland and elsewhere have developed to the stage where radically new building forms and styles are generally undesirable. Thus, for historical reasons, both new and existing buildings must, to a large extent, conform to the established norms of the region in external appearance.
8) For maximum dissemination, and more widespread benefits from solar energy, new solar collectors and cladding materials must be suitable for retro-fitting in the large number of existing homes and buildings at reasonable cost.

It is known from US-A-4511755, US-A-4033324 and US-A-4458672 to provide solar collection devices with profiled light-receiving surfaces formed by lenses, in the case of 4057048 and 4511755, and having spherical glass particles in the case of 4033324. The profiled light receiving surfaces serve to refract the incoming solar energy and which is focused onto collector surfaces at which heat transfer can take place.

However, these references do not teach incorporation of such panels into building panels to be incorporated in a building as a component part of the structure thereof, and with improved ability to transmit solar radiation incident thereon at all angles of incidence.

According to the invention there is provided a solar collection building panel having an outer surface which is intended to receive solar energy incident thereon, said panel comprising:
a substrate made of a material which can transmit solar radiation and having an outer surface serving to receive solar radiation energy and an inner surface serving to transmit the solar energy after passage through the substrate;
a profiled coating applied to the outer surface of the substrate and formed by transparent beads which are closely spaced to each other and which receive the incident solar radiation;
characterised in that the beads are at least partly spherical, so as to refract the solar radiation to pass through the substrate and to focus on an energy-receiving medium; and in that the outer surface of the panel is moulded or pressed to simulate the appearance of a building roof material.

For the avoidance of doubt, the outer surface or surfaces is / are intended to receive the incident radiation and the inner surface or surfaces is / are intended to transmit the radiation received by the outer surface or surfaces, to the conducting fluid in the case of thermal uses, and to the semi-conductor surface in the case of photovoltaic uses.

In view of the part-spherical shape of each bead, radiation incident at an angle on the outer surface of the panel which might otherwise suffer at least partial reflection from a plane surface can pass through the beads and then via a non-refractive interface with the surface of the substrate into or through the substrate.

Consequently, a transparent or opaque cladding panel according to the invention can considerably enhance the transmission efficiency of incident radiation thereon, as compared with existing types of cladding panel, e.g. as in conventional designs of solar collectors.

The application of the beads on the surface or surfaces of the substrate will take place in any convenient manner consistent with reliable adhesion of the beads to the surface or surfaces of the substrate and in a way which permits the major part of the radiation passing into each bead to exit into or through the substrate via the interface or interfaces.

In one possible arrangement, the beads may be bonded to the surface or surfaces of the substrate by use of an intermediate material which provides a suitable monolithic bond between the beads and the substrate, and which has a refractive index which is compatible with that of the substrate and the beads, so that the transmission losses due to reflection or refraction at the interface or interfaces are minimised.

Preferably, the exposed parts of the beads are hemispherical in shape with very close spacing between adjacent beads, the latter being of suitably small sizes, allowing the proportion of uncovered or uncoated area of the substrate to be kept to a minimum, thereby providing a very efficient ratio of incident to transmitted energy.

Any suitable material or materials, natural or man-made, transparent or opaque, may be utilised to make the substrate, including glass, plastics, ceramics, semi-conductors, metals and minerals and similarly suitable material or materials may be used to make the beads. Spherical glass beads of the order of 10 microns are readily available, and if smaller diameters become available in the future, they can also be used in the invention.

The outer surface or surfaces of the panel may take any desired shape but in a preferred development of the invention, the outer surface is shaped/moulded to simulate a conventional external component of a building, i.e. a plurality of building elements.

The panel may be manufactured with suitable colour tinting to simulate the colour of a conventional building component without substantial alteration in the sensible energy transmitting properties of the panel.

If required, the inner surface or surfaces of the panel may be arranged to direct the transmitted radiation to any suitable transducer, e.g. an array of photovoltaic cells, or to a heat exchange medium such as fluid pumped or circulated in thermal contact with the inner surface or surfaces of the substrate, or a tandem arrangement as previously described, or simply to the interior of a building or enclosure.

A radiation transmitting panel according to the invention, in a preferred embodiment thereof, may comprise any number of solar panels which can be used to make the entire roof of a building a solar collector. For maximum efficiency, such a roof should allow the transmission of solar radiation irrespective of incidence angle or roof orientation. Such a roof should also allow any number of solar applications (e.g. thermal, photovoltaic, lighting etc.) to be performed simultaneously, whilst retaining the uniform external appearance of a traditional roofing material (e.g. slate, tile, thatch etc.) All these objectives can be achieved by means of a preferred embodiment of the invention.

Thus, a radiation transmitting panel according to the invention can be manufactured from any suitable material produced using the profiled coating, applied to a durable transparent substrate. However, while use of the invention as an external component of a building is one particular preferred use, it is envisaged that a radiation transmitting panel according to the invention can be used in other situations. For example, non-solar applications may be employed, including amongst others improved lamp diffusers, non-reflective television screens and computer displays, picture frames, light-powered calculators and watches, etc.

The invention will now be described in more detail, by way of example only, with reference to the accompanying drawings, in which:-
Figure 1 is a two dimensional representation of an air / glass interface, illustrating how part of the incident radiation falling onto the plane glass surface is divided into transmitted and reflected components;
Figure 2 is a diagram schematically illustrating the relationship between the angle of incidence and the reflecting power of plane glass;
Figure 3 is an illustration, again for the two dimensional case, showing the zone for acceptable levels of transmission through plane glass;
Figure 4 is a schematic illustration of part of a profiled surface coating applied to a radiation transmitting panel according to the invention;
Figure 5 illustrates how all of the sky (omni-directional) radiation can be transmitted through a hemispherical surface-coating portion of the panel;
Figure 6 is a schematic three dimensional illustration, to an enlarged scale, showing the radiation transmission properties of the improved cladding panel;
Figure 7 is a detailed perspective view, to an enlarged scale, of a portion of a radiation transmitting panel according to the invention, comprising a substrate having a profiled surface-coating applied thereon and formed by a plurality of closely adjacent hemispherical transparent or opaque beads;
Figure 8 is an external view showing one typical example of use of a radiation transmitting panel according to the invention, to form a part of a solar roof panel on a building; and,
Figure 9 to 11 show schematically examples of different means which may be adopted in order to convert incident radiation energy into another form of energy.

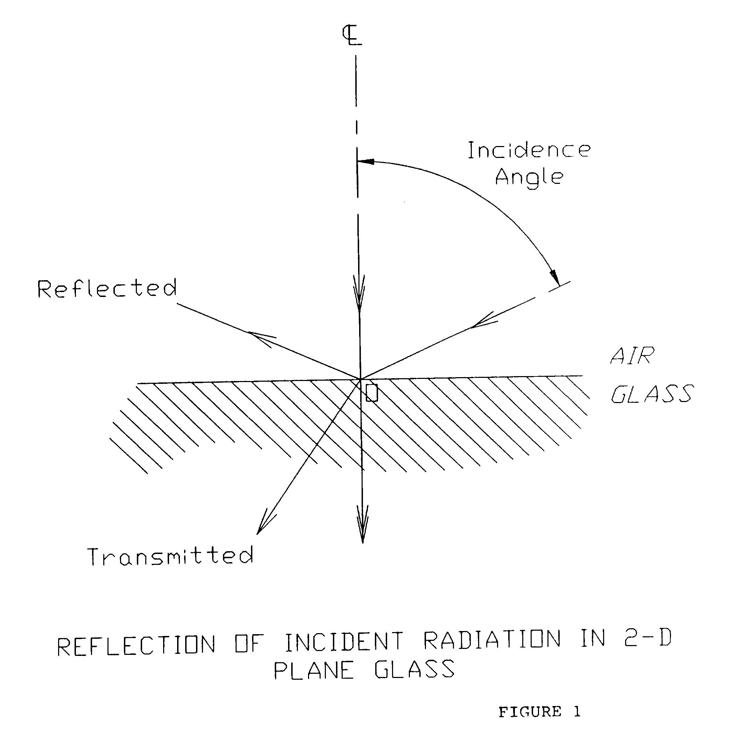

Before a detailed description will be made of a preferred embodiment of the invention, the way in which radiation is reflected and transmitted through a plane surface will be described with reference to Figures 1 to 3. The reflecting power of any surface depends primarily on the angle of incidence of the incident radiation and, to a lesser extent, on the wavelength of the radiation, the age and smoothness of the surface. Plane glass is perhaps the most widely used solar cladding material and will serve to illustrate the basic principles which apply to this invention.

Figure 1 is a two dimensional representation of an air / glass interface, illustrating how the incident radiation on the surface is divided into transmitted and reflected components. At zero incidence angle, less than 5% of the solar radiation will be reflected and the rest transmitted. However, as the incidence angle approaches 90°, almost all the radiation will be reflected.

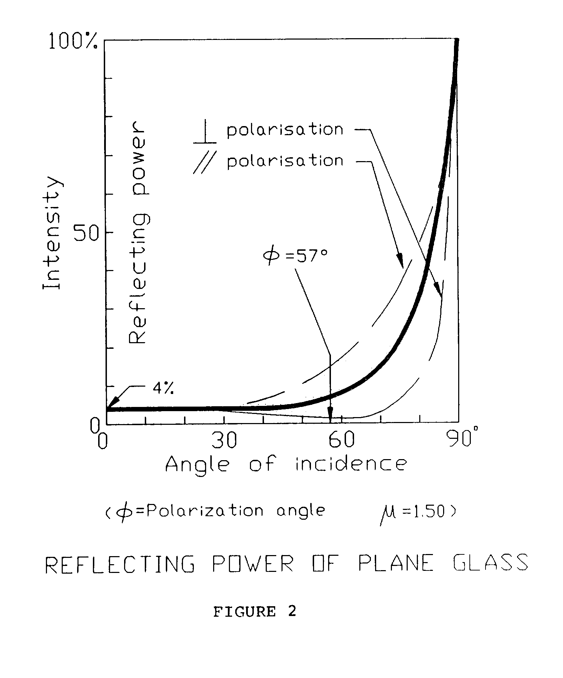

Figure 2 schematically represents the relationship between incidence angle and reflecting power.

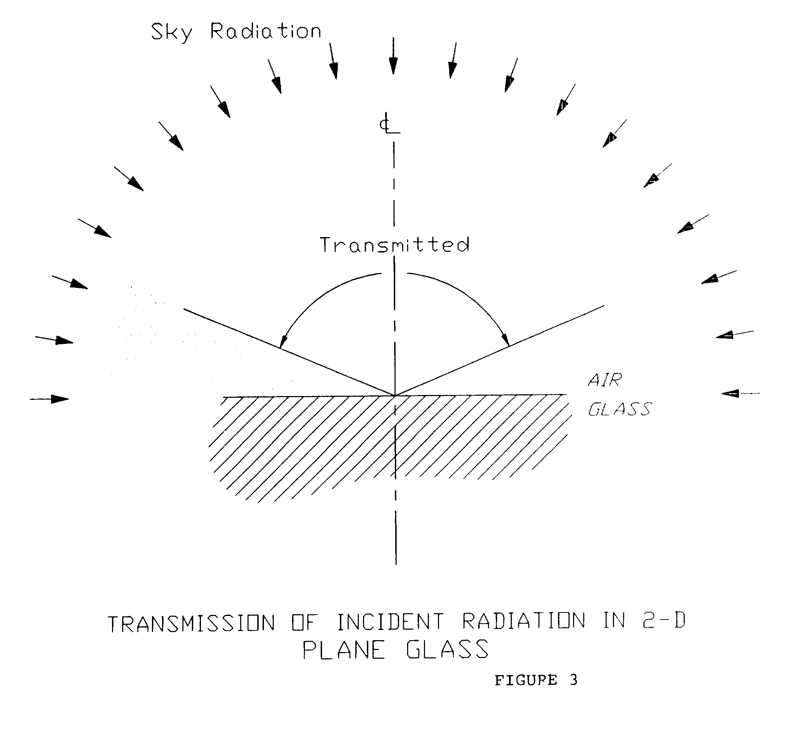

Figure 3 infers (again for the two dimensional case) the zone for acceptable transmission levels through plane glass.

Thus, in order to minimise reflection, the incidence angle of the incoming radiation must be normal to the surface at all times.

This can be achieved by:
a) Ensuring that the direction of incoming radiation remains fixed at all times and positioning the surface normal to this direction. This is clearly very difficult to achieve at a stationary point on the Earth's surface;
b) Continuously re-orienting the surface so that the incoming radiation is always normal to the surface. This approach has led to the development of tracking solar collectors but these are only effective in dealing with the direct component of solar radiation.

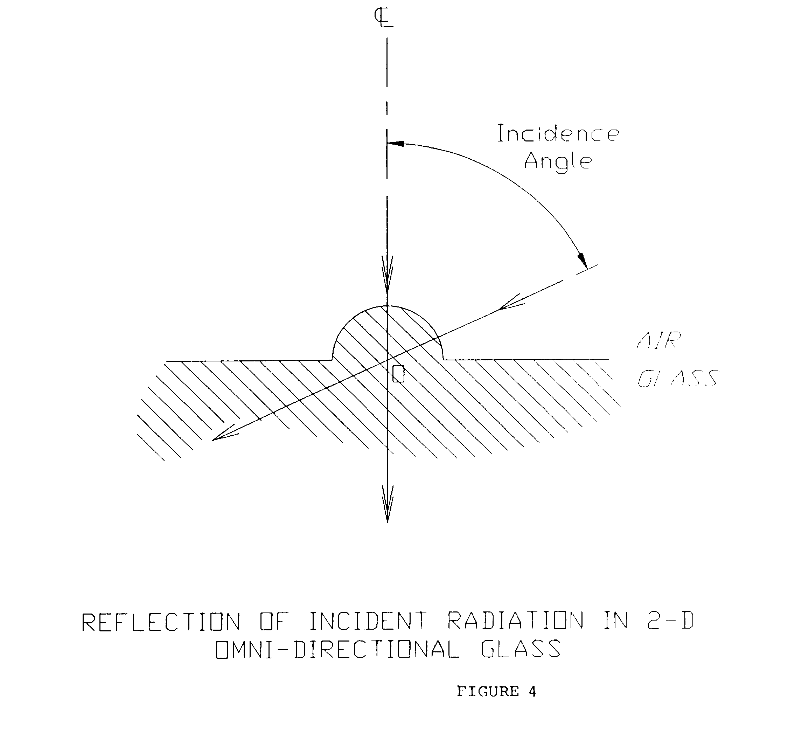

Such tracking systems are expensive, ungainly, and require considerable maintenance;
c) Modifying the shape or profile of the surface so that all incoming solar radiation intersects the surface normally, irrespective of the original incidence angle. One example of a profiled surface-coating according to the invention will be described with reference to Figures 4 to 7, which will achieve this objective in the following way.

With reference to the two dimensional representation in Figure 1, it can be seen that a significant proportion of the oblique radiation incident at a point "O" will be reflected. However, if the profile of the surface at "O" were replaced by the "infinitesimally small" hemispherical profile in Figure 4, the oblique radiation would intersect the surface normally and maximum transmission would occur.

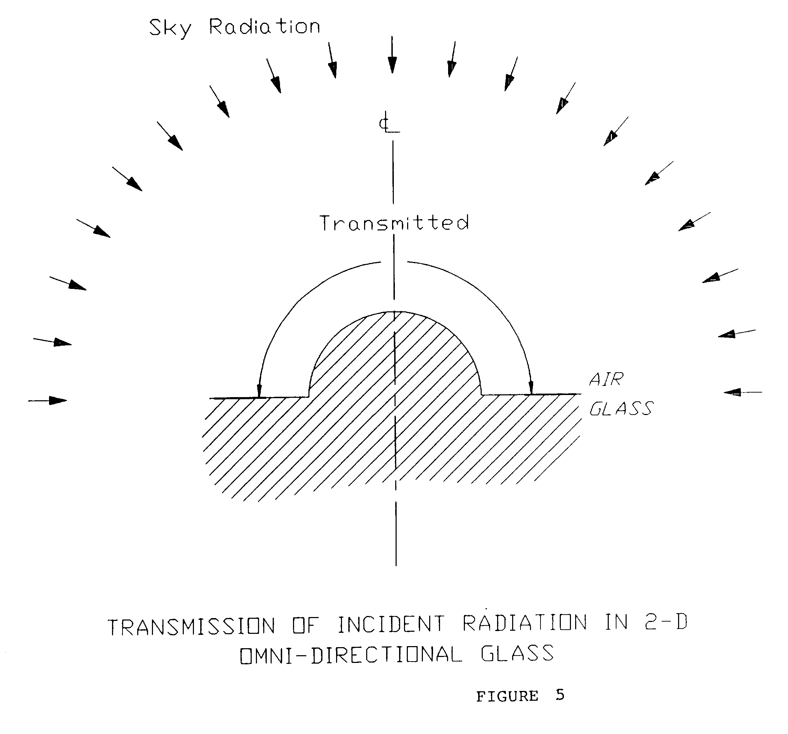

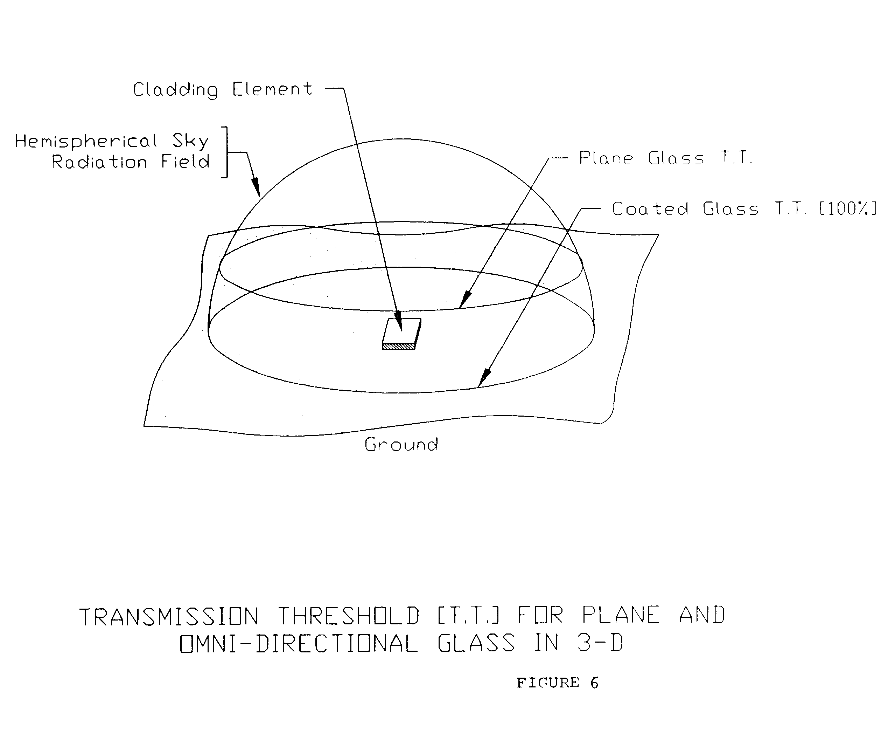

Since the direction of the oblique radiation is arbitrary, the omni-directional nature of the new profile may be established as in Figure 5. The above findings are translated to the three dimensional case in Figure 6, giving some indication of the improvement in transmission efficiency which is theoretically possible if reflection can be controlled in the manner described.

A profiled coating, composed of a single layer of closely spaced transparent spheres of the order of size previously described, when embedded in a compatible transparent or opaque surface, should increase the overall transmission of solar radiation obliquely incident onto the outer surface. Factors to be considered, however, include how closely the "infinitesimally small" hemispherical profile can be approximated, the number of hemispheres which can be accommodated on an element of surface area, and the nature of the interface between the spheres and the original plane surface.

Spherical glass beads of the order of 10 microns in size are readily available, which would indicate that even smaller dimensions may be achieved in future. By carefully grading the size of the embedded spheres over any element of surface area, it should be possible to obtain coverages approaching 100%. Finally, a monolithic bond between the spheres and a substrate with comparable refractive index should eliminate any transmission losses due to reflection or refraction at the interface.

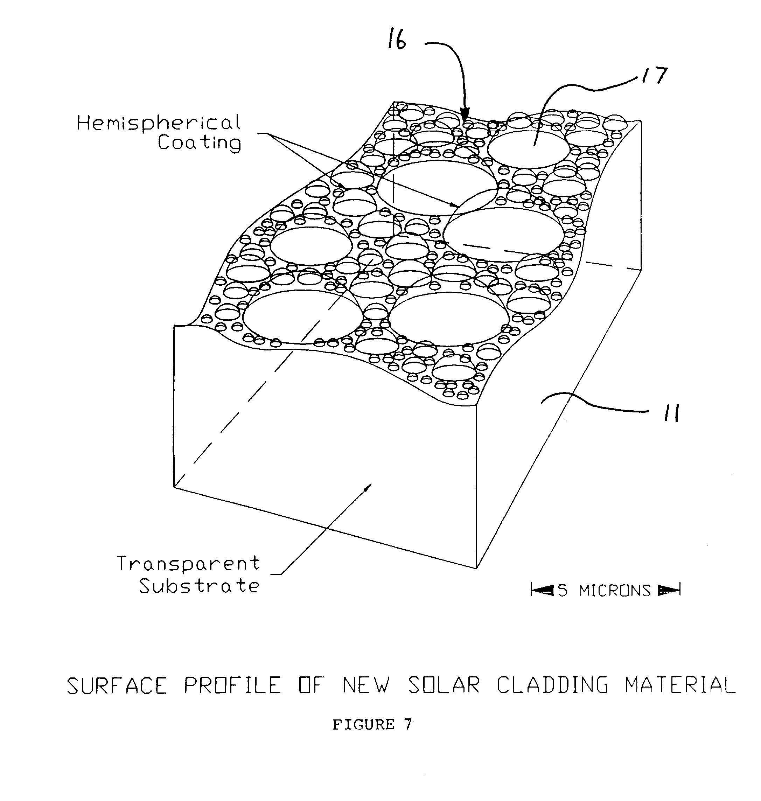

Figure 7 shows a schematic representation of how an element of coated cladding would appear when greatly magnified, dimensions are purely arbitrary at this stage, and comprising substrate 11 made of a material which is capable of transmitting solar radiation and is transparent or translucent, and a profiled coating 16 formed of hemispherical beads 17.

There is potential to reduce reflection and therefore to enhance the energy "absorption" properties of opaque/metallic materials, using opaque/metallic spherical beads based on these same principles.

By way of example only, use of a radiation transmitting panel as a component part of the structure of a building will now be described.
a) By applying the profiled coating described in the preceding section to the surface of a durable substrate (e.g., glass, acrylic, etc.), it should be possible to produce a range of solar cladding materials for use in buildings and other solar and related applications. Since the coating permits the omni-directional transmission of radiation, the substrate can be moulded into any shape, and in any desired texture, without significantly affecting transmission efficiency.
b) Since improved transmission also means less reflection, the cladding can be produced in different grades of matt finish, simply by altering the surface density of the coating.
c) The final appearance of the cladding can be modified, lastly, by tinting the profiled coating to any desired colour, or alternatively by colouring the substrate, the collector plate or device encapsulated by the cladding.

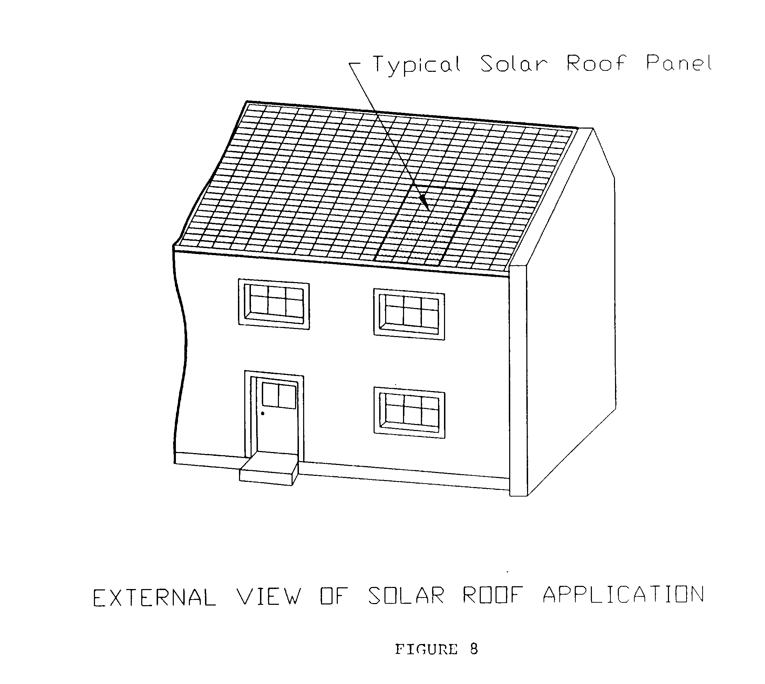

A new solar roofing system, based on the concept of a profiled coating is now described. Identical coated solar cladding panels, made to look like a traditional roofing material (slate, tile, thatch etc.) would be used in fabricating the entire roof. They would then facilitate the transmission of solar energy to at least one type of solar energy device (thermal, photovoltaic etc.), and to the interior of the building (for lighting), in a format that is compatible in external appearance with traditional roofing systems as shown in Figure 8.

The methods outlined for the new solar roof are also appropriate for the production of solar collectors and cladding materials to replace other building components such as walls, doors, windows etc., thus helping to add variety to the building design and construction process in the future.

The radiant energy which is incident on the exposed outer surface of the panel e.g. solar insolation energy, passes through the profiled coating formed by the hemispherical beads, and then through the underlying substrate, and is then captured by any suitable type of energy transducer according to requirements i.e. depending upon the medium which is required to gain energy as a result of the insolation falling on the panel.

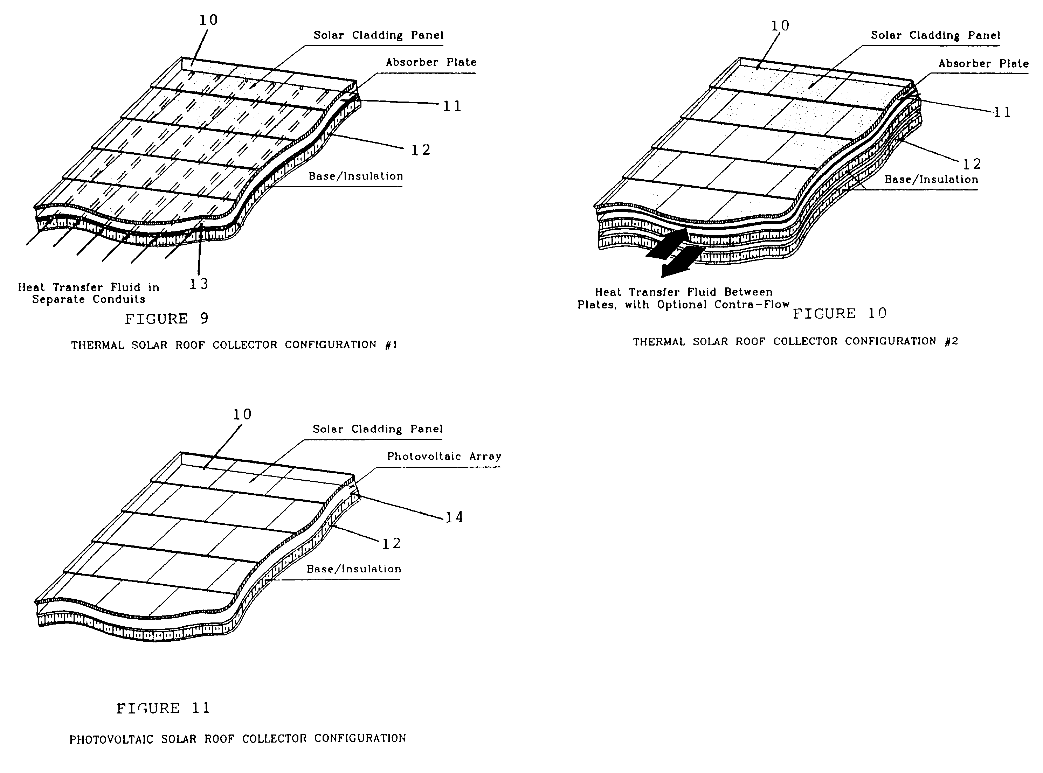

Purely by way of example only, Figures 9 to 11 show schematically a number of different ways in which this could be achieved. These examples are illustrated schematically, and it will be evident that there will be many other different ways of converting incident radiation energy into other forms of energy gained by any required energy absorbing medium.

Figure 9 shows schematically a thermal solar roof collector configuration, comprising an upper solar cladding panel 10 which simulates any desired form of roof tile or cladding, an absorber plate 11, and a base / insulation layer 12. The absorber plate 11 contains conduits 13 running through the plate which convey heat transfer fluid to absorb thermal energy gained by the absorber plate 11.

Figure 10 shows a further arrangement of thermal solar roof collector configuration, having upper solar cladding panel 10, absorber plate 11, base / insulation 12, and passages defined between the underside of absorber plate 11 and base insulation 12, and also within the base insulation 12, for passage of heat transfer fluid between the plates, and optional contra-flow capability.

Figure 11 shows schematically a further example of energy transducer means, in which a photovoltaic array 14 is arranged between solar cladding panel 10 and base insulation 12.

## Claims

1. A solar collection building panel (10) having an outer surface which is intended to receive solar energy incident thereon, said panel comprising:
a substrate (11) made of a material which can transmit solar radiation and having an outer surface serving to receive solar radiation energy and an inner surface serving to transmit the solar energy after passage through the substrate;
a profiled coating (16) applied to the outer surface of the substrate and formed by transparent beads (17) which are closely spaced to each other and which receive the incident solar radiation;
characterised in that the beads (17) are at least partly spherical, so as to refract the solar radiation to pass through the substrate and to focus on an energy-receiving medium; and in that the outer surface of the panel is moulded or pressed to simulate the appearance of a building roof material.

2. A panel according to claim 1, characterised in that the beads (17) are spherical beads.

3. A panel according to claim 1 or 2, characterised in that the beads (17) are adhered to the surface of the substrate (11) by use of material which promotes a monolithic bond between the beads and the substrate, and which has a refractive index which is compatible with the substrate and the beads, so as to minimise transmission losses due to reflection or refraction at the interface between each bead and the surface.

4. A panel according to any one of claims 1 to 3, characterised in that the beads (17) have a transverse dimension of the order of 10 microns.

5. A panel according to any one of claims 1 to 4, characterised by tinting in the substrate (11) and / or the surface coating beads (17) to simulate the colour of a conventional building component.

6. A panel according to any one of claims 1 to 5, characterised in that the profiled coating (16) is nonplanar.

7. A panel according to any one of claims 1 to 6, characterised in that the substrate (11) is transparent or translucent.

8. A panel according to any one of claims 1 to 7, characterised in that photo-voltaic cells are arranged on a lower surface of the substrate.

9. A panel according to any one of claims 1 to 7, characterised by being formed as part of a solar thermal panel to which a pumped or circulated supply of fluid can be supplied to permit the transfer of radiant energy to the fluid.

## Patentansprüche

1. Solarenergiekollektor-Gebäudeplatte (10) mit einer Außenfläche zur Aufnahme von darauf auftreffender Solarenergie, wobei die Platte aufweist:
ein Substrat (11) aus einem für Solarstrahlung durchlässigen Material mit einer Außenfläche zur Aufnahme von Solarstrahlungsenergie und einer Innenfläche, die dazu dient, die Solarenergie nach dem Duchgang durch das Substrat zu übertragen,
eine auf der Außenfläche des Substrats angebrachte profilierte Beschichtung (16), die von transparenten Sicken (17) gebildet ist, die geringen Abstand voneinander haben und die auftreffenden Solarstrahlung aufnehmen,
dadurch gekennzeichnet,
daß die Sicken (17) zumindest teilweise sphärische Form haben, so daß sie die Solarstrahlung brechen und diese durch das Substrat wandert und auf einem Energie aufnehmenden Medium fokussiert wird,
und daß die Außenfläche der Platte so geformt oder geprägt ist, daß sie das Erscheinungsbild eines Gebäudedachmaterials nachbildet.

2. Platte nach Anspruch 1, dadurch gekennzeichnet, daß die Sicken (17) sphärische Sicken sind.

3. Platte nach Anspruch 1 oder 2, dadurch gekennzeichnet, daß die Sicken auf die Außenfläche des Substrats (11) mit Hilfe eines Materials geklebt sind, das eine monolitische Bindung zwischen den Sicken und dem Substrat begünstigt und einen Brechungsindex besitzt, der mit dem Substrat und den Sicken kompatibel ist, so daß durch Reflexion oder Brechung an der Trennfläche zwischen den einzelnen Sicken und der Fläche bedingte Übertragungsverluste minimiert werden.

4. Platte nach einem der Ansprüche 1 bis 3, dadurch gekennzeichnet, daß die Querabmessung der Sicken (17) in der Größenordnung von 10 Mikrometer liegt.

5. Platte nach einem der Ansprüche 1 bis 4, dadurch gekennzeichnet, daß das Substrat (11) und/oder die Sicken der Oberflächenbeschichtung eingefärbt sind, um die Farbe einer herkömmlichen Gebäudekomponente nachzubilden.

6. Platte nach einem der Ansprüche 1 bis 5, dadurch gekennzeichnet, daß die profilierte Beschichtung (16) nicht eben ist.

7. Platte nach einem der Ansprüche 1 bis 6, dadurch gekennzeichnet, daß das Substrat (11) durchsichtig oder durchscheinend ist.

8. Platte nach einem der Ansprüche 1 bis 7, dadurch gekennzeichnet, daß auf einer unteren Fläche des Substrats photovoltaische Zellen angebracht sind.

9. Platte nach einem der Ansprüche 1 bis 7, dadurch gekennzeichnet, daß sie als Teil einer Solarwärmeplatte ausgebildet ist, die an einen durch Pumpwirkung oder Zirkulation betriebenen Fluidzulauf anschließbar ist, um die Übertragung von Strahlungsenergie auf das Fluid zu ermöglichen.

## Revendications

1. Panneau de bardage de captation du rayonnement solaire (10) ayant une surface extérieure qui est destinée à recevoir l'énergie solaire qui vient frapper celle-ci, ledit panneau comprenant:
un substrat (11) fait d'un matériau qui peut transmettre le rayonnement solaire et comportant une surface extérieure servant à recevoir l'énergie de rayonnement solaire et une surface intérieure servant à transmettre l'énergie solaire après son passage au travers du substrat;
un revêtement profilé (16) appliqué sur la surface extérieure du substrat et constitué par des bulles transparentes (17) qui sont disposées très proches les unes des autres et qui reçoivent le rayonnement solaire incident;
caractérisé en ce que les bulles (17) sont au moins partiellement sphériques de manière à réfracter le rayonnement solaire pour qu'il passe au travers du substrat et pour le concentrer sur un support de réception d'énergie; et en ce que la surface extérieure du panneau est moulée ou comprimée de manière à simuler l'aspect d'un matériau de construction de toiture.

2. Panneau selon la revendication 1, caractérisé en ce que les bulles (17) sont des bulles sphériques.

3. Panneau selon la revendication 1 ou 2, caractérisé en ce que les bulles (17) sont rendues adhérentes à la surface du substrat (11) par l'utilisation d'un matériau qui favorise une liaison intime entre les bulles et le substrat, et qui a un indice de réfraction qui est compatible avec le substrat et les bulles, de manière à réduire au minimum les pertes lors de la transmission, dues à la réflexion ou à la réfraction au niveau de l'interface entre chaque bulle et la surface.

4. Panneau selon l'une quelconque des revendications là 3, caractérisé en ce que les bulles (17) ont une dimensions transversale de l'ordre de 10 microns.

5. Panneau selon l'une quelconque des revendications 1 à 4, caractérisé en ce le substrat (11) et/ou le revêtement superficiel des bulles (17) sont teintées pour simuler la couleur d'un élément de construction classique.

6. Panneau selon l'une quelconque des revendications 1 à 5, caractérisé en ce que le revêtement profilé (16) n'est pas plan.

7. Panneau selon l'une quelconque des revendications 1 à 6, caractérisé en ce que le substrat (11) est transparent ou translucide.

8. Panneau selon l'une quelconque des revendications 1 à 7, caractérise en ce que des piles photovoltaïques sont disposées sur la surface inférieure du substrat.

9. Panneau selon l'une quelconque des revendications 1 à 7, caractérisé en que qu'il fait partie d'un panneau thermique solaire, dans lequel un courant de fluide pompé ou recyclé peut être envoyé pour permettre la transmission de l'énergie de rayonnement au fluide.
